# FASCICULE DE BREVET EUROPEEN

(11) **EP 3 262 730 B1**
(45) Date de publication et mention de la délivrance du brevet: **11.09.2019**
(21) Numéro de dépôt: 16707693.4
(22) Date de dépôt: 25.02.2016
(51) Int. Cl.: H02G 13/00

(54) **CONTROLE DE SYSTEME DE PROTECTION CONTRE LA FOUDRE**
STEUERUNG EINES BLITZSCHUTZSYSTEMS
CONTROLLING A LIGHTNING PROTECTION SYSTEM

(30) Priorité: 27.02.2015 FR 1551680
(43) Date de publication de la demande: 03.01.2018
(73) Titulaire: ArianeGroup SAS, 75015 Paris (FR)
(72) Inventeur: ASPAS PUERTOLAS, Jesus, 75007 Paris (FR); NGUYEN, François, 78000 Houilles (FR)
(74) Mandataire: Brevalex
(86) Numéro de dépôt international: PCT/EP2016/054006
(87) Numéro de publication internationale: WO 2016/135254

(56) Documents cités:
- EP-A1- 2 559 972
- WO-A1-2004/111686
- WO-A1-2007/107158
- FR-A1- 2 979 761
- US-A- 5 463 317
- US-A1- 2011 142 644
- CHUANTONG WANG ET AL: "Open Circuit Resonant (SansEC) Sensor for Composite Damage Detection and Diagnosis in Aircraft Lightning Environments", 4TH AIAA ATMOSPHERIC AND SPACE ENVIRONMENTS CONFERENCE, 25 juin 2012 (2012-06-25), XP055238556, Reston, Virigina DOI: 10.2514/6.2012-2792 ISBN: 978-1-62410-192-2
- National Instruments: "Principes fondamentaux de l'analyse de r?seaux", , 19 November 2012 (2012-11-19), XP055335170, Retrieved from the Internet: URL:http://www.ni.com/white-paper/11640/fr / [retrieved on 2017-01-13]

## Description

### DOMAINE TECHNIQUE

La présente invention se rapporte au domaine des structures exposées à la foudre, telles que les éoliennes, et aux systèmes de protection d'une telle structure contre la foudre.

L'invention concerne plus spécifiquement un dispositif et un procédé de contrôle d'un tel système de protection contre la foudre.

### ÉTAT DE LA TECHNIQUE ANTÉRIEURE

Les pales des éoliennes sont majoritairement réalisées en matériau composite avec par exemple un renfort fibreux réalisé en fibre de verre.

La protection d'une pale d'une éolienne de ce type contre la foudre repose conventionnellement sur un système comportant des récepteurs de foudre métalliques affleurant la surface externe de la pale et répartis le long de celle-ci en étant reliés à un câble de descente électriquement conducteur positionné à l'intérieur de la pale et relié à la terre par des moyens de liaison intégrés au moyeu du rotor de l'éolienne.

Comme la foudre s'attache préférentiellement sur les récepteurs de foudre, le courant foudre est conduit par le câble de descente jusqu'aux moyens de liaison à la terre.

Ce type d'architecture de système de protection contre la foudre donne généralement satisfaction mais est relativement complexe à contrôler. Le contrôle d'un dispositif de protection contre la foudre consiste globalement à vérifier la continuité électrique du dispositif pour que le courant de foudre qui s'attache sur un récepteur soit effectivement conduit vers la terre et n'endommage pas, ou le moins possible, la structure de la pale d'éolienne.

Pour contrôler l'intégrité d'un système classique de protection contre la foudre, il est nécessaire qu'un opérateur accède aux récepteurs depuis l'extérieur, par exemple en utilisant une nacelle, afin de connecter à un même appareil de contrôle les récepteurs et l'extrémité du câble de descente. Cette opération est complexe à mettre en oeuvre et coûteuse.

En outre, la méthode classique repose sur une mesure de résistance entre deux points du réseau fermé, positionnés respectivement aux extrémités opposées de la pâle. Cette méthode nécessite deux points d'accès pour effectuer les mesures.

US 2011/142644 divulgue une pale de rotor d'éolienne qui comprend une pluralité de récepteurs de foudre. Au moins un circuit conducteur de foudre en boucle fournit un chemin redondant à chaque récepteur de foudre pour conduire un coup de foudre à la terre.

US 5 463 317 divulgue un appareil pour vérifier l'intégrité du blindage sur un câblage électrique, par la détermination de la fréquence de résonance de la fonction de transfert de tension du fil blindé. Une modification de la fréquence de résonance indique une modification de l'inductance propre provoquée par une défaillance du circuit blindé.

### EXPOSÉ DE L'INVENTION

L'invention vise à résoudre les problèmes de la technique antérieure en fournissant un procédé de contrôle d'un système de protection contre la foudre comportant un chemin de descente ayant une structure en arbre, caractérisé en ce qu'il comporte des étapes de :
- émission d'un signal radiofréquence à une extrémité du chemin de descente,
- mesure d'un coefficient de réflexion,
- détermination de fréquences de résonance du chemin de descente,
- comparaison des fréquences de résonance déterminées avec des fréquences de résonance préétablies. Le contrôle peut être effectué au niveau du moyeu du rotor, qui est accessible de manière relativement aisée par un opérateur.

La mise en oeuvre de l'invention ne nécessite l'accès qu'à un seul point du chemin de descente.

Les fréquences de résonance dépendent des longueurs des différentes sections du chemin de descente. Leur détermination et leur comparaison avec des fréquences de résonance préétablies permet de savoir si le chemin de descente a été ou non endommagé.

Selon une caractéristique préférée, l'étape de détermination des fréquences de résonance du chemin de descente comporte la détermination des fréquences de résonance en fonction de minimaux locaux de l'amplitude du coefficient de réflexion en fonction de la fréquence.

Selon une autre caractéristique préférée, l'étape de détermination des fréquences de résonance du chemin de descente comporte la détermination des fréquences de résonance en fonction de points d'inflexion de la phase du coefficient de réflexion en fonction de la fréquence.

Selon une encore une autre caractéristique préférée, l'étape de détermination des fréquences de résonance du chemin de descente comporte la détermination des fréquences de résonance en fonction de maxima locaux de la dérivée de la phase du coefficient de réflexion en fonction de la fréquence.

Il est bien-sûr possible d'effectuer la détermination des fréquences de résonance selon plusieurs de ces possibilités, de façon à fiabiliser cette détermination en comparant les résultats.

Selon une caractéristique préférée, l'étape de comparaison comporte la comparaison des fréquences de résonance avec des fréquences de résonance du chemin de descente sans défaut.

Ainsi, il est possible de déterminer si le chemin de descente a été endommagé ou pas.

Selon une caractéristique préférée, l'étape de comparaison comporte la comparaison des fréquences de résonance avec des fréquences de résonance du chemin de descente comportant des coupures préétablies.

Ainsi, lorsque le chemin de descente a été endommagé, il est possible de déterminer le défaut du chemin de descente.

Selon une caractéristique préférée, le procédé de contrôle d'un système de protection contre la foudre est mis en oeuvre dans un analyseur vectoriel de réseau.

Selon une caractéristique préférée, le procédé de contrôle d'un système de protection contre la foudre est mis en oeuvre pour un système de protection contre la foudre d'une éolienne.

L'invention concerne aussi un dispositif de contrôle d'un système de protection contre la foudre comportant un chemin de descente ayant une structure en arbre, caractérisé en ce qu'il comporte
- des moyens d'émission d'un signal radiofréquence à une extrémité du chemin de descente,
- des moyens de mesure d'un coefficient de réflexion,
- des moyens de détermination de fréquences de résonance du chemin de descente,
- des moyens de comparaison des fréquences de résonance déterminées avec des fréquences de résonance préétablies.

L'invention concerne encore un système de protection contre la foudre d'une éolienne, caractérisé en ce qu'il comporte le dispositif de contrôle d'un système de protection contre la foudre tel que précédemment présenté. Le dispositif et le système de protection présentent des avantages analogues à ceux précédemment présentés.

L'invention concerne encore un programme d'ordinateur comportant des instructions pour l'exécution des étapes du procédé tel que précédemment présenté, lorsque ledit programme est exécuté par un ordinateur.

L'invention concerne encore un support d'enregistrement lisible par un ordinateur sur lequel est enregistré un programme d'ordinateur comprenant des instructions pour l'exécution des étapes du procédé précédemment présenté.

### BRÈVE DESCRIPTION DES DESSINS

D'autres caractéristiques et avantages apparaîtront à la lecture de la description suivante d'un mode de réalisation préféré donné à titre d'exemple non limitatif, décrit en référence aux figures dans lesquelles :
La figure 1 représente une éolienne,
La figure 2 représente une pale d'éolienne équipée d'un système de protection contre la foudre,
La figure 3a représente un circuit électrique équivalent du système de protection contre la foudre, en configuration de contrôle, selon un mode de réalisation de la présente invention,
La figure 3b représente un mode de réalisation de dispositif de contrôle, selon un mode de réalisation de la présente invention,
La figure 4 représente un contrôle du système de protection contre la foudre, selon un mode de réalisation de la présente invention,
Les figures 5a à 5c représentent respectivement l'amplitude, la phase, la dérivée de phase d'un coefficient de réflexion en fonction de la fréquence, selon un mode de réalisation de la présente invention.

### EXPOSÉ DÉTAILLÉ DE MODES DE RÉALISATION PARTICULIERS

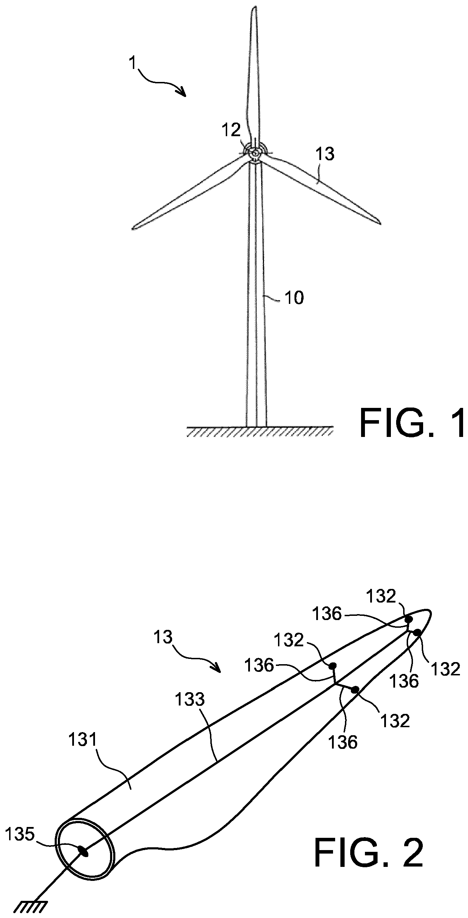

Selon un mode de réalisation représenté à la **figure 1****,** une éolienne 1 comprend de manière générale un mât 10 fixé au sol, une nacelle portée par le mât et logeant un moyeu de rotor 12 supportant des pales 13 et monté à rotation autour d'un axe de rotor. Chaque pale 13 comporte une base raccordée au moyeu de rotor 12 et se prolongeant en un profil aérodynamique effilé jusqu'à une extrémité, d'une manière bien connue.

La structure mécanique de l'éolienne est classique, mais son système de protection contre la foudre est décrit dans la suite.

La **figure 2** illustre schématiquement une pale 13 de l'éolienne 1. La pale 13 est globalement formée d'un ou plusieurs longeron(s) non représenté(s) et d'une peau extérieure aérodynamique 131 solidaire du longeron. Ces éléments sont classiques et ne seront pas détaillées ici.

La pale 13 comporte un système de protection contre la foudre.

Ce système comporte au moins un récepteur de foudre 132. Il s'agit d'un élément métallique affleurant la surface externe, situé à proximité de l'extrémité de la pale. De préférence, le système de protection contre la foudre comporte une pluralité de récepteurs de foudre 132, répartis sur la surface externe de la pale. Dans l'exemple représenté à la figure 2, la pale comporte deux récepteurs d'extrémité disposés symétriquement dans un plan transversal à un plan de symétrie de la pale, et deux récepteurs médians, également disposés symétriquement dans le même plan transversal. Bien entendu, le nombre et la disposition des récepteurs peuvent être différents.

Les récepteurs 132 sont reliés à un ou plusieurs câbles de descente foudre 133, par l'intermédiaire de câbles 136. Ce système de conducteurs électriques forme une structure en arbre, comportant différentes sections de tronc et de branches. Cette structure forme ainsi un chemin de descente qui s'étend entre le ou les récepteurs situé(s) à proximité de l'extrémité de la pale et le moyeux 12 au niveau duquel le chemin de descente comporte une borne 135 qui est reliée à la terre.

Dans la suite, on s'intéresse plus particulièrement au chemin de descente.

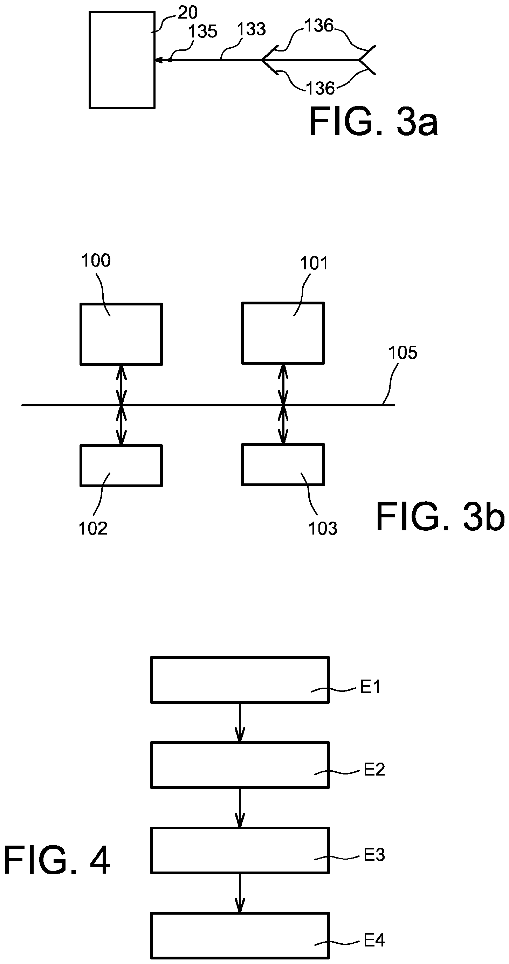

La **figure 3a** représente le circuit électrique équivalent du système de protection contre la foudre, en configuration de contrôle, selon un mode de réalisation de la présente invention.

Le contrôle a pour but de mesurer la continuité du circuit électrique du système de protection contre la foudre.

Pour cela, la borne de connexion 135 du chemin de descente est déconnectée de la terre et est reliée à un dispositif de contrôle qui permet l'injection d'un signal électrique radiofréquence dans le chemin de descente, puis une mesure du signal réfléchi. Le dispositif de contrôle comporte de préférence un analyseur vectoriel de réseau 20. Cette opération est effectuée au niveau du moyeu du rotor. Dans un autre mode de réalisation, l'analyseur vectoriel de réseau 20 peut être connecté à un quelconque récepteur de foudre 132. Il n'est alors pas nécessaire de déconnecter la borne 135 de la terre.

L'analyseur vectoriel de réseau 20 est utilisé pour effectuer une mesure radiofréquence à un seul port.

Le principe de la mesure est basé sur la réflectométrie dans le domaine fréquentiel.

La **figure 3b** représente un mode de réalisation particulier de dispositif de contrôle, selon l'invention.

Le dispositif de contrôle a la structure générale d'un ordinateur. Il comporte notamment un processeur 100 exécutant un programme d'ordinateur mettant en oeuvre le procédé selon l'invention qui va être décrit dans la suite, une mémoire 101, une interface d'entrée 102 et une interface de sortie 103.

Ces différents éléments sont classiquement reliés par un bus 105.

L'interface d'entrée 102 est relié à la borne de connexion 135 du chemin de descente. L'interface 102 produit des données représentant les mesures effectuées.

Le processeur 100 exécute les traitements exposés dans la suite. Ces traitements sont réalisés sous la forme d'instructions de code du programme d'ordinateur qui sont mémorisées par la mémoire 101 avant d'être exécutées par le processeur 100.

L'interface de sortie 103 est une interface homme-machine 104 destinée à fournir des informations à un opérateur sur le chemin de descente qui a été contrôlé.

La **figure 4** représente le procédé de contrôle du système de protection contre la foudre, selon un mode de réalisation de la présente invention. Le procédé comporte des étapes E1 à E4 mise en oeuvre dans l'analyseur vectoriel de réseau 20.

L'étape E1 est l'émission d'un signal radiofréquence sinusoïdal à une extrémité du chemin de descente. L'amplitude et la phase du signal émis sont prédéterminées. La fréquence du signal émise varie entre deux bornes.

L'étape suivante E2 est la mesure de l'amplitude de la phase du signal réfléchi sur le même port, dans le but de déterminer les fréquences de résonance du chemin de descente.

On mesure plus particulièrement le coefficient de réflexion à l'entrée, dit paramètre S₁₁, avec l'analyseur vectoriel de réseau 20. Le paramètre S₁₁ est le rapport entre les amplitudes et les phases des signaux émis et réfléchis. Lorsque la fréquence du signal émis varie, on obtient un balayage en fréquence du paramètre S₁₁.

A partir de ce balayage en fréquence du paramètre S₁₁, on détermine les fréquences de résonance du chemin de descente, qui dépendent des longueurs des différentes sections des branches 136 et du tronc 133 du chemin de descente.

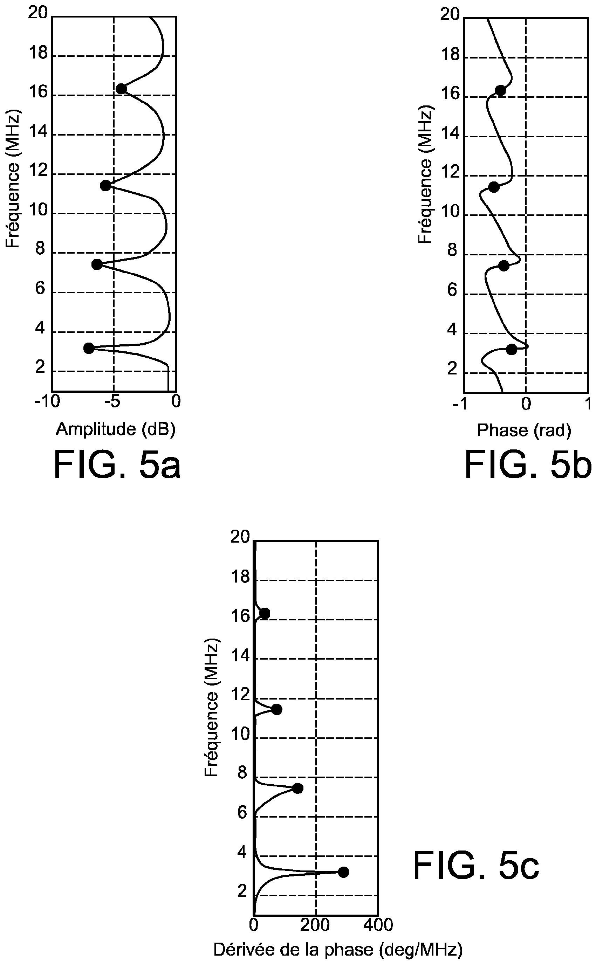

Les différentes variantes de détermination des fréquences de résonance sont illustrées par les figures 5a à 5c.

La **figure 5a** représente l'amplitude du coefficient de réflexion en fonction de la fréquence. Les fréquences de résonance peuvent être déterminées en fonction des minimaux locaux de cette amplitude.

La **figure 5b** représente la phase du coefficient de réflexion en fonction de la fréquence. Les fréquences de résonance correspondent aux points d'inflexion de la courbe de phase.

La **figure 5c** représente la dérivée de phase du coefficient de réflexion en fonction de la fréquence. Les fréquences de résonance correspondent à des maxima locaux de cette courbe.

Dans l'exemple représenté, quatre fréquences de résonances sont mises en évidence.

Le fait de travailler sur la dérivée de phase permet de s'affranchir d'une éventuelle dérive lente de l'offset ainsi que d'un éventuel défaut de calibrage de l'appareil.

Les fréquences de résonance dépendent des longueurs des différentes sections du chemin de descente.

L'étape suivante E3 est la comparaison des fréquences de résonance précédemment détectées avec des fréquences de résonance prédéterminées. Ces fréquences de résonance prédéterminées comportent de préférence plusieurs jeux. Tout d'abord, elles comprennent les fréquences de résonance du chemin de descente sans défaut. Il s'agit de la signature du chemin de descente. Ensuite, il est possible d'établir des jeux de fréquences correspondants à des coupures préétablies du chemin de descente. Cela permet d'identifier des défauts du chemin de descente.

Ainsi, il est possible de déterminer si le chemin de descente est intègre et dans la négative, de qualifier le défaut détecté.

L'étape suivante E4 est la production d'un message indiquant le résultat de l'étape précédente de comparaison. Par exemple, si les fréquences de résonances déterminées correspondent à celles du chemin de descente sans défaut, alors le chemin de descente n'a pas subi de dégradation.

Dans le cas contraire, le chemin de descente est dégradé, et si les fréquences de résonances déterminées correspondent à des fréquences de résonance associées à une dégradation prédéfinie, alors la dégradation du chemin de descente correspond à cette dégradation prédéfinie.

Le contrôle est ainsi réalisé de manière économique et simple. Un opérateur accède à la borne de connexion du chemin de descente, au niveau du moyeu de rotor 12.

L'invention a été décrite pour une pale d'éolienne, mais elle peut être transposée à d'autres applications. Par exemple, le contrôle selon l'invention peut être appliqué à un système de protection contre la foudre dans un bâtiment.

## Revendications

1. Procédé de contrôle d'un système de protection contre la foudre comportant un chemin de descente ayant une structure en arbre, **caractérisé en ce qu'**il comporte des étapes de :
- émission (E1) d'un signal radiofréquence à une extrémité du chemin de descente,
- mesure (E2) d'un coefficient de réflexion,
- détermination (E2) de fréquences de résonance du chemin de descente,
- comparaison (E3) des fréquences de résonance déterminées avec des fréquences de résonance préétablies.

2. Procédé de contrôle d'un système de protection contre la foudre selon la revendication 1, **caractérisé en ce que** l'étape de détermination des fréquences de résonance du chemin de descente comporte la détermination des fréquences de résonance en fonction de minimaux locaux de l'amplitude du coefficient de réflexion en fonction de la fréquence.

3. Procédé de contrôle d'un système de protection contre la foudre selon la revendication 1, **caractérisé en ce que** l'étape de détermination des fréquences de résonance du chemin de descente comporte la détermination des fréquences de résonance en fonction de points d'inflexion de la phase du coefficient de réflexion en fonction de la fréquence.

4. Procédé de contrôle d'un système de protection contre la foudre selon la revendication 1, **caractérisé en ce que** l'étape de détermination des fréquences de résonance du chemin de descente comporte la détermination des fréquences de résonance en fonction de maxima locaux de la dérivée de la phase du coefficient de réflexion en fonction de la fréquence.

5. Procédé de contrôle d'un système de protection contre la foudre selon l'une quelconque des revendications 1 à 4, **caractérisé en ce que** l'étape de comparaison comporte la comparaison des fréquences de résonance avec des fréquences de résonance du chemin de descente sans défaut.

6. Procédé de contrôle d'un système de protection contre la foudre selon l'une quelconque des revendications 1 à 5, **caractérisé en ce que** l'étape de comparaison comporte la comparaison des fréquences de résonance avec des fréquences de résonance du chemin de descente comportant des coupures préétablies.

7. Procédé de contrôle d'un système de protection contre la foudre selon l'une quelconque des revendications 1 à 6, **caractérisé en ce qu'**il est mis en oeuvre dans un analyseur vectoriel de réseau.

8. Procédé de contrôle d'un système de protection contre la foudre selon l'une quelconque des revendications 1 à 7, **caractérisé en ce qu'**il est mis en oeuvre pour un système de protection contre la foudre d'une éolienne.

9. Dispositif de contrôle d'un système de protection contre la foudre comportant un chemin de descente (133, 136) ayant une structure en arbre, **caractérisé en ce qu'**il comporte
- des moyens d'émission d'un signal radiofréquence à une extrémité (135) du chemin de descente,
- des moyens (20) de mesure d'un coefficient de réflexion,
- des moyens (20) de détermination de fréquences de résonance du chemin de descente,
- des moyens (20) de comparaison des fréquences de résonance déterminées avec des fréquences de résonance préétablies.

10. Système de protection contre la foudre d'une éolienne, **caractérisé en ce qu'**il comporte le dispositif de contrôle d'un système de protection contre la foudre selon la revendication 9.

11. Programme d'ordinateur comportant des instructions pour l'exécution des étapes du procédé selon la revendication 1 lorsque ledit programme est exécuté par un ordinateur.

12. Support d'enregistrement lisible par un ordinateur sur lequel est enregistré un programme d'ordinateur comprenant des instructions pour l'exécution des étapes du procédé selon la revendication 1.

## Patentansprüche

1. Verfahren zur Steuerung eines Systems zum Blitzschutz, umfassend einen Ableitungspfad, der eine Baumstruktur hat, **dadurch gekennzeichnet, dass** es die folgenden Schritte umfasst:
- Emittieren (E1) eines Funkfrequenzsignals an einem Ende des Ableitungspfads,
- Messen (E2) eines Reflexionskoeffizienten,
- Bestimmen (E2) von Resonanzfrequenzen des Ableitungspfads,
- Vergleichen (E3) der bestimmten Resonanzfrequenzen mit zuvor festgelegten Resonanzfrequenzen.

2. Verfahren zur Steuerung eines Systems zum Blitzschutz nach Anspruch 1, **dadurch gekennzeichnet, dass** der Schritt des Bestimmens der Resonanzfrequenzen des Ableitungspfads die Bestimmung der Resonanzfrequenzen als Funktion von lokalen Minima der Amplitude des Reflexionskoeffizienten als Funktion der Frequenz umfasst.

3. Verfahren zur Steuerung eines Systems zum Blitzschutz nach Anspruch 1, **dadurch gekennzeichnet, dass** der Schritt des Bestimmens der Resonanzfrequenzen des Ableitungspfads die Bestimmung der Resonanzfrequenzen als Funktion von Wendepunkten der Phase des Reflexionskoeffizienten als Funktion der Frequenz umfasst.

4. Verfahren zur Steuerung eines Systems zum Blitzschutz nach Anspruch 1, **dadurch gekennzeichnet, dass** der Schritt des Bestimmens der Resonanzfrequenzen des Ableitungspfads die Bestimmung der Resonanzfrequenzen als Funktion von lokalen Maxima der Ableitung der Phase des Reflexionskoeffizieten als Funktion der Frequenz umfasst.

5. Verfahren zur Steuerung eines Systems zum Blitzschutz nach einem der Ansprüche 1 bis 4, **dadurch gekennzeichnet, dass** der Schritt des Vergleichens das Vergleichen der Resonanzfrequenzen mit Resonanzfrequenzen des Ableitungspfads ohne Fehler umfasst.

6. Verfahren zur Steuerung eines Systems zum Blitzschutz nach einem der Ansprüche 1 bis 5, **dadurch gekennzeichnet, dass** der Schritt des Vergleichens das Vergleichen der Resonanzfrequenzen mit Resonanzfrequenzen des Ableitungspfads, umfassend zuvor festgelegte Unterbrechungen, umfasst.

7. Verfahren zur Steuerung eines Systems zum Blitzschutz nach einem der Ansprüche 1 bis 6, **dadurch gekennzeichnet, dass** es in einem vektoriellen Netzanalysator durchgeführt wird.

8. Verfahren zur Steuerung eines Systems zum Blitzschutz nach einem der Ansprüche 1 bis 7, **dadurch gekennzeichnet, dass** es für ein System zum Blitzschutz einer Windkraftanlage durchgeführt wird.

9. Vorrichtung zur Steuerung eines Systems zum Blitzschutz, umfassend einen Ableitungspfad (133, 136), der eine Baumstruktur hat, **dadurch gekennzeichnet, dass** sie Folgendes umfasst:
- Mittel zum Emittieren eines Funkfrequenzsignals an einem Ende (135) des Ableitungspfads,
- Mittel (20) zum Messen eines Reflexionskoeffizienten,
- Mittel (20) zum Bestimmen von Resonanzfrequenzen des Ableitungspfads,
- Mittel (20) zum Vergleichen der bestimmten Resonanzfrequenzen mit zuvor festgelegten Resonanzfrequenzen.

10. System zum Blitzschutz einer Windkraftanlage, **dadurch gekennzeichnet, dass** es die Vorrichtung zur Steuerung eines Systems zum Blitzschutz nach Anspruch 9 umfasst.

11. Computerprogramm, umfassend Instruktionen zum Ausführen der Schritte des Verfahrens nach Anspruch 1, wenn das Programm durch einen Computer ausgeführt wird.

12. Aufzeichnungsträger, der durch einen Computer auslesbar ist, auf dem ein Computerprogramm gespeichert ist, das Instruktionen zur Durchführung der Schritte des Verfahrens nach Anspruch 1 umfasst.

## Claims

1. Method for testing a lightning protection system comprising a down path with a tree structure, **characterised in that** it comprises the following steps:
- transmitting (E1) a radiofrequency signal at one end of the down path,
- measuring (E2) a reflection coefficient,
- determining (E2) resonant frequencies of the down path,
- comparing (E3) the determined resonant frequencies with predetermined resonant frequencies.

2. Method for testing a lightning protection system according to claim 1, **characterised in that** the step of determining resonant frequencies of the down path includes determination of resonant frequencies as a function of local minimum values of the amplitude of the reflection coefficient as a function of the frequency.

3. Method for testing a lightning protection system according to claim 1, **characterised in that** the step of determining resonant frequencies of the down path includes determination of resonant frequencies as a function of inflection points of the phase of the reflection coefficient as a function of the frequency.

4. Method for testing a lightning protection system according to claim 1, **characterised in that** the step of determining resonant frequencies of the down path includes determination of resonant frequencies as a function of local maximum values of the derivative of the phase of the reflection coefficient as a function of the frequency.

5. Method for testing a lightning protection system according to any one of claims 1 to 4, **characterised in that** the comparison step includes a comparison of resonant frequencies with resonant frequencies of the down path without any faults.

6. Method for testing a lightning protection system according to any one of claims 1 to 5, **characterised in that** the comparison step includes a comparison of resonant frequencies with resonant frequencies of the down path containing predetermined breaks.

7. Method for testing a lightning protection system according to any one of claims 1 to 6, **characterised in that** it is used in a vector network analyser.

8. Method for testing a lightning protection system according to any one of claims 1 to 7, **characterised in that** it is used for a wind turbine lightning protection system.

9. Device for testing a lightning protection system comprising a down path (133, 136) with a tree structure, **characterised in that** includes:
- means of transmitting a radiofrequency signal at one end (135) of the down path,
- means (20) of measuring a reflection coefficient,
- means (20) of determining resonant frequencies of the down path,
- means (20) of comparing the determined resonant frequencies with predetermined resonant frequencies.

10. Wind turbine lightning protection system, **characterised in that** it comprises the testing device for a lightning protection system according to claim 9.

11. Computer program containing instructions for execution of the steps in the method according to claim 1 when said program is executed by a computer.

12. Storage medium that can be read by a computer, in which a computer program is stored containing instructions for execution of the steps in the method according to claim 1.
